# FASCICULE DE BREVET EUROPEEN

(11) **EP 2 485 260 B1**
(45) Date de publication et mention de la délivrance du brevet: **05.06.2019**
(21) Numéro de dépôt: 11306740.9
(22) Date de dépôt: 22.12.2011
(51) Int. Cl.: H01L 27/146, G01J 5/04, G01J 5/10, G01J 5/20, H01L 23/10, H01L 23/26

(54) **Procéde d'assemblage et de fermeture hermétique d'un boîtier d'encapsulation**
Montage- und hermetisches Schließverfahren eines Einkapselungsgehäuses
Method for assembly and airtight sealing of an encapsulation box

(30) Priorité: 02.02.2011 FR 1150815
(43) Date de publication de la demande: 08.08.2012
(73) Titulaire: ULIS, 38113 Veurey Voroize (FR)
(72) Inventeur: Perratone, Frédéric, 38000 Grenoble (FR); Simon, Didier, 38470 Rovon (FR)
(74) Mandataire: Cabinet Laurent & Charras

(56) Documents cités:
- EP-A1- 2 065 930
- US-A- 3 654 529
- US-A1- 2002 056 898

## Description

### DOMAINE DE L'INVENTION

La présente invention a trait au domaine des composants optiques, électroniques ou microélectroniques, fonctionnant sous vide ou sous pression réduite. De manière plus spécifique, l'invention trouve plus particulièrement application dans le domaine de l'imagerie à base de microbolomètres, (c'est-à-dire fonctionnant à température ambiante), tel que notamment dans le domaine de la détection infrarouge thermique.

Un certain nombre de composants, qu'ils soient actifs (micro-vibrateurs, accéléromètres) ou passifs (détecteurs notamment infrarouges), requièrent pour leur fonctionnement de fonctionner sous vide ou sous faible pression. Ce faisant, pour leur besoin de fonctionnement, de tels composants sont encapsulés dans un boitier hermétique, susceptible de conserver la pression de fonctionnement requise lors de leur montage. En outre, il peut s'avérer qu'en raison même, soit de leur montage, soit de leur mode de fonctionnement, soit encore de leur température de fonctionnement, la pression au sein du boitier hermétique en question évolue dans le temps et notamment augmente, de manière susceptible d'altérer de fait leurs performances, et nécessitant dès lors la mise en oeuvre de dispositifs ou d'organes appropriés pour augmenter la longévité des composants en question.

On se heurte donc à une problématique de nature principalement économique pour la réalisation de tels composants, liée à la taille des composants en question, aux constituants mis en oeuvre et/ou techniques d'assemblage, ainsi qu'au rendement desdites technologies, et enfin à la durée de vie effective des composants, directement liée à l'évolution de la pression dans le boitier, pression qui, ainsi que rappelé ci-dessus, doit rester suffisamment basse pendant toute la durée de vie dudit composant.

La description qui suit est plus particulièrement orientée vers l'imagerie thermique. Il doit cependant être présent à l'esprit que l'invention a vocation à s'appliquer à tout composant dont le fonctionnement nécessite le vide ou une pression réduite aux fins de conserver ses performances.

### ETAT ANTERIEUR DE LA TECHNIQUE

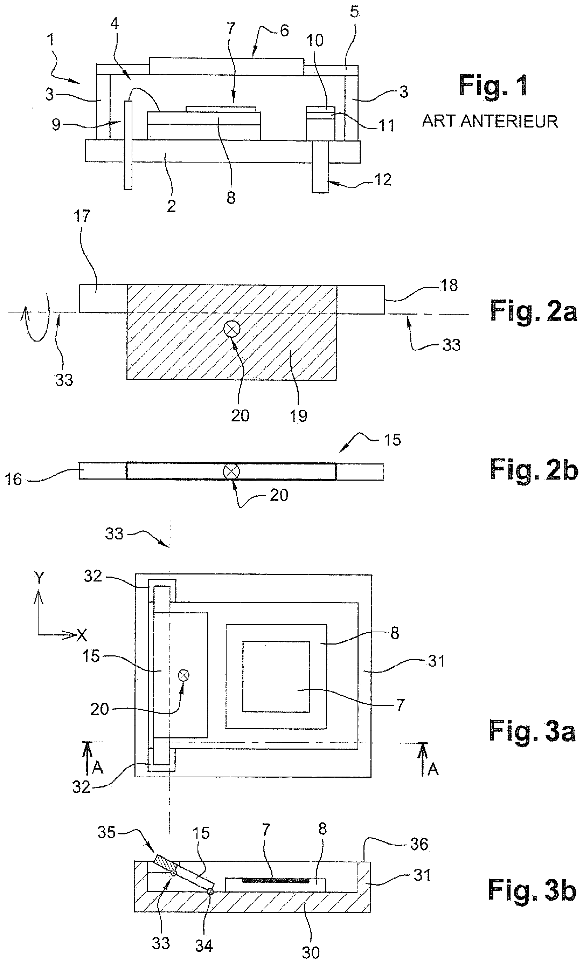

On a représenté en relation avec la figure 1, une vue schématique en section d'un boitier d'encapsulation d'un détecteur bolométrique conforme à l'état antérieur de la technique, et donc typiquement mis en oeuvre pour la détection infrarouge thermique.

Le boitier **1** comporte fondamentalement un substrat **2,** par exemple réalisé en un matériau céramique ou en métal, voire en une combinaison de ces deux types de matériaux. Ce substrat constitue la base du boitier **1.** Il est muni de parois latérales **3,** l'enceinte **4** ainsi définie étant obturée au moyen d'un couvercle ou capot **5,** en l'espèce muni d'une fenêtre **6** transparente à la gamme de longueurs d'onde d'intérêt, et typiquement 8 - 12 micromètres ou 3 - 5 micromètres s'agissant de l'imagerie infrarouge.

Le boitier **1** ainsi défini comporte au sein de l'enceinte **4,** un détecteur bolométrique **7,** positionné sous la fenêtre **6.** Ce détecteur bolométrique, par exemple une rétine bidimensionnelle de microbolomètres, est généralement élaboré en surface d'un circuit électronique de formation du signal utile **8,** lui-même relié à l'extérieur par une série d'entrées/sorties **9** de faible puissance, habituellement par câblage filaire. Ces entrées/sorties sont connectées à l'électronique du système intégrant le détecteur, typiquement une caméra, par des moyens habituels de type soudure ou insertion sur carte PCB.

Le scellement des parois latérales **3** sur le substrat **2** et du capot ou couvercle **5** sur l'extrémité supérieure des parois latérales **3,** est réalisé de telle sorte que la pression régnant à l'intérieur de l'enceinte **4** est typiquement inférieure à 10⁻² mbar, et ce pendant toute la durée de vie du produit. Ce scellement hermétique est réalisé également de telle sorte que le taux de fuite soit typiquement inférieur à 10⁻¹² mbar. 1/s à l'hélium.

La conservation de cette pression réduite est assurée au moyen d'un élément traditionnellement appelé « *getter* » **10**, c'est-à-dire un organe comprenant un matériau susceptible d'absorber, et de manière générale de pomper, les molécules de gaz relarguées lors de la vie du composant de détection, originaires de toutes les surfaces des constituants en relation avec le volume interne de l'enceinte **4.**

Un tel matériau getter peut être massif, c'est-à-dire constitué de poudre frittée sous forme généralement cylindrique, éventuellement traversé par un fil en métal réfractaire servant à la fixation et à l'activation électrique par effet Joule du getter. Le getter peut également être déposé par divers procédés, tels que la sérigraphie ou le dépôt sous vide type PVD (acronyme anglo-saxon pour « *Physical Vapor Depostion* ») sur un support de préférence métallique **11,** qui peut, comme pour les getters massifs, servir de moyen de fixation et de moyen de connexion électrique du getter. La connexion électrique **12** est, dans le cas d'espèce, une entrée/sortie de forte puissance pour permettre l'activation électrique par effet Joule du getter.

De tels dispositifs de l'art antérieur ont par exemple été décrits dans les documents US-7 470 904, US 4 956 554 et US 5 317 157.

L'activation du getter est réalisée par un échauffement, après que l'enceinte **4** ait été évacuée par pompage, du matériau getter actif, habituellement entre 300 et 900°C selon l'alliage métallique mis en oeuvre dans la partie active du getter. Cet échauffement est obtenu soit par effet Joule, c'est-à-dire par passage d'un courant électrique dans le support métallique résistif, soit encore par élévation de la température de l'enceinte du boitier, donc du getter, à la température d'activation requise.

Le document EP 2 065 930 A1 divulgue un procédé d'assemblage et de fermeture hermétique d'un boîtier (figure 19, [0075]), constitué d'une paroi latérale (9) rapportée sur ou solidaire d'un substrat (3), le volume ainsi défini recevant au moins un composant (7) fonctionnant sous vide ou sous pression réduite, ou plus généralement sous ambiance atmosphérique contrôlée, ledit volume étant obturé par un capot d'herméticité (12) scellé sur ladite paroi latérale (9), ce procédé consistant : - à déposer sur la face supérieure (10b) de la paroi latérale (9) un élément de jonction métallique également qualifié de préforme de brasage (10b) ; - à déposer le capot supérieur (12) au-dessus et en contact avec ladite préforme de brasage (10b) ; - à soumettre l'ensemble ainsi réalisé à l'ambiance souhaitée en termes de nature de gaz et de pression de fonctionnement du composant ([0060]); - à élever la température à une valeur au moins supérieure à la température de fusion du matériau constitutif de la préforme de brasage ([0060]); - puis à abaisser ladite température pour induire la solidification dudit matériau de brasage, et corollairement le scellement du capot sur la paroi latérale ([0060]). Dans ce procédé connu, la paroi latérale (9) reçoit un élément fonctionnel (18), monté en porte-à-faux. Dans le procédé du D2, on procède, après mise en place dudit élément fonctionnel (figure 19), le dépôt de la préforme de brasage (10b), puis du capot (12) induit le positionnement de l'élément fonctionnel selon son mode opérationnel.

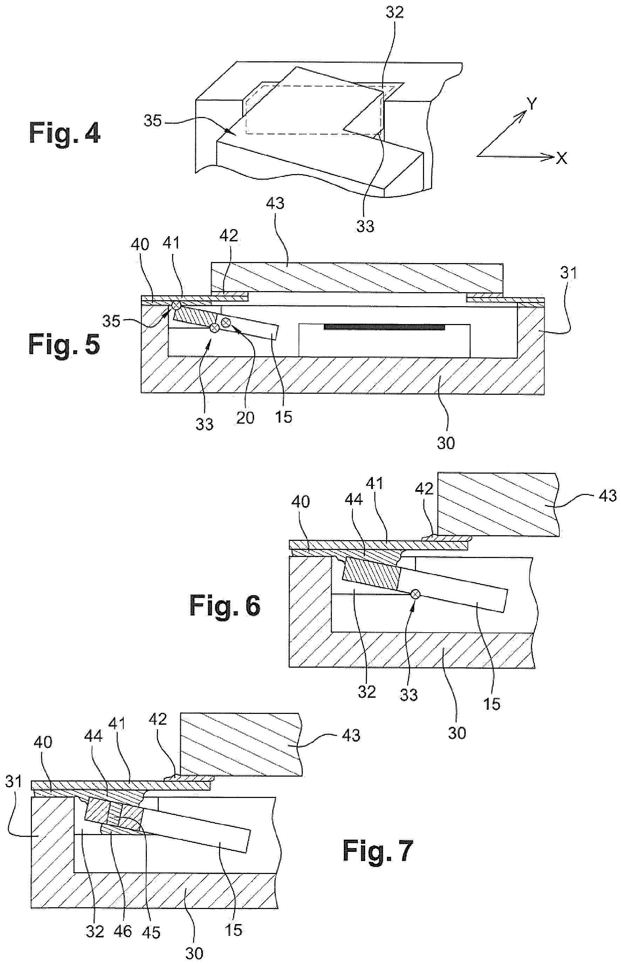

Le document US 2002/0056898 A1 divulgue un dispositif composé d'un composant (51) intégré dans un boîtier hermétique (figure 5) au sein duquel est susceptible de régner le vide ou une pression réduite, ou de manière générale une ambiance atmosphérique contrôlée, ledit boîtier étant constitué d'une paroi latérale (50) rapportée sur ou solidaire d'un substrat (50), le volume ainsi défini étant obturé par scellement d'un capot supérieur (56). Le boîtier intègre également un élément fonctionnel (54, 55) fixée sur la paroi latérale à l'aide d'une colle (58). La capot supérieur (56) est fixée à la paroi latérale à l'aide d'une couche de colle (57).

Quel que soit le boitier mis en oeuvre, la fixation du getter 10 au sein de ce dernier est réalisée lors d'une étape spécifique, distincte de l'étape de fixation du détecteur et de manière générale des autres éléments nécessaires à l'assemblage des divers constituants du composant (produit) fini. Cette opération est coûteuse en outillage, en matériau, et en outre fortement consommatrice de temps de main d'oeuvre.

L'objectif recherché par la présente invention vise précisément à simplifier cette opération.

### EXPOSE DE L'INVENTION

Elle vise tout d'abord un procédé d'assemblage et de fermeture hermétique d'un boitier, constitué d'une paroi latérale rapportée sur, ou solidaire d'un substrat, le volume ainsi défini recevant au moins un composant fonctionnant sous vide ou sous pression réduite, ou plus généralement sous ambiance atmosphérique contrôlée, ledit volume étant obturé par un capot d'herméticité scellé sur ladite paroi latérale, ce procédé étant défini par la revendication 1.

En d'autres termes, l'invention consiste à prévoir en une seule étape l'opération de fixation de l'élément fonctionnel, et par exemple de l'élément getter, et de scellement du boitier.

Selon l'invention, lors de l'élévation de température, le matériau de brasage de la préforme migre et assure, en suite de sa fusion, la solidarisation de l'élément fonctionnel au boiter.

L'invention vise également le procédé du type en question, plus particulièrement destiné à la réalisation d'un boitier hermétique intégrant une rétine d'imagerie infrarouge et d'un élément getter. Selon cette application, le capot supérieur intègre une fenêtre transparente à au moins une gamme de longueurs d'onde déterminée, positionnée sensiblement en regard de la rétine d'imagerie infrarouge, typiquement constituée d'un détecteur bolométrique rapporté directement ou indirectement sur le substrat du boitier.

L'invention vise également un dispositif composé d'un composant intégré dans un boitier hermétique au sein duquel est susceptible de régner le vide ou une pression réduite, ou de manière générale une ambiance atmosphérique contrôlée, ledit boitier étant constitué d'une paroi latérale rapportée sur, ou solidaire d'un substrat, le volume ainsi défini étant obturé par scellement d'un capot supérieur. Selon l'invention, ce dispositif est défini par la revendication 5.

Selon une variante de la forme de réalisation précédente, la paroi latérale présente deux évidements ou logements au voisinage de son extrémité supérieure, et ménagés sensiblement de manière opposée l'un à l'autre, et corollairement, l'élément fonctionnel comporte deux saillies ou excroissances aptes à être reçues dans lesdits évidements ou logements, lesdites saillies ou excroissances n'étant pas alignées avec le centre de gravité dudit élément fonctionnel et leur coopération avec les évidements ou logements constituant un axe d'articulation, autour duquel l'élément fonctionnel est susceptible de basculer d'une position non opérationnelle à une position opérationnelle, après scellement du capot sur la paroi latérale définissant le boitier.

Selon une définition plus générale, le centre de gravité de l'élément fonctionnel est externe au périmètre de sustentation dudit élément, lui-même formé par l'enveloppe des périmètres de coopération entre les excroissances et les évidements.

### BREVE DESCRIPTION DES FIGURES

La manière dont l'invention peut être réalisée et les avantages qui en découlent, ressortiront mieux de l'exemple de réalisation qui suit, donné à titre indicatif et non limitatif, à l'appui des figures annexées.
La figure 1 est, comme déjà dit, une représentation schématique en section d'un boitier conforme à l'état antérieur de la technique.
Les figures 2a et 2b sont des vues respectives de dessus et latérale d'un élément getter conforme à une forme de réalisation particulière de l'invention.
Les figures 3a et 3b sont des représentations schématiques vu de dessus et latéralement, illustrant la mise en place de l'élément getter des figures 2a et 2b au sein d'un boitier conforme à l'invention, préalablement à l'opération de scellement dudit boitier.
La figure 4 est une représentation schématique tendant à illustrer de manière plus précise un logement ménagé au sein de la paroi latérale du boitier coopérant avec une partie ou excroissance de l'élément getter, et conforme à la forme de réalisation des figures 3a et 3b.
La figure 5 est une représentation schématique en vue latérale du boitier des figures 3a et 3b après mise en place du capot d'encapsulation, en l'espèce muni d'une fenêtre transparente à une gamme de longueurs d'onde déterminée.
La figure 6 est une représentation schématique en vue latérale plus précise de la figure 5 après fusion de la préforme.
La figure 7 est une vue analogue à la figure 6 d'une variante de réalisation de l'invention.

### DESCRIPTION DETAILLEE DE L'INVENTION

On a représenté, en relation avec les figures 2a et 2b, un élément getter **15** mis en oeuvre dans le cadre d'une forme particulière de réalisation de la présente invention. Fondamentalement, celui-ci est constitué d'une lame métallique **16.** Cette lame métallique 16 est avantageusement recouverte d'un traitement de surface galvanique constitué de nickel et d'or au moins, au niveau de zones **17** et **18,** en l'espèce opposées l'une à l'autre, zones formant excroissance ou saillie par rapport au reste de l'élément, et dont la fonction sera décrite en détail ultérieurement.

Le reste de la lame métallique **16** est recouvert sur l'une de ses faces principales, mais avantageusement au niveau de ses deux faces, d'un matériau getter proprement dit, typiquement susceptible d'absorber par chimisorption les gaz présents dans l'enceinte définie par le boitier de l'invention, et ce donc selon une zone **19,** en l'espèce rectangulaire.

On peut observer sur la figure 2a que la zone principale active **19** de l'élément getter **15** de forme rectangulaire, est de dimension nettement plus importante que les zones **17** et **18.** De fait, le centre de gravité **20** de l'élément getter **15** est décalé par rapport à la zone de liaison reliant les zones **17** et **18,** la raison de ce décalage étant indiquée ci-après.

On a représenté en relation avec les figures 3a et 3b la mise en place de l'élément getter **15** au sein du boitier conforme à l'invention.

Ce boitier de forme sensiblement parallélépipédique est défini par un fond 30, en l'espèce un substrat, et une paroi latérale **31,** continue. Le fond **30** du boitier reçoit un détecteur bolométrique **7** associé à son circuit de lecture **8,** et ce de manière connue.

En revanche, selon l'invention, la paroi latérale **31** est pourvue au voisinage de sa surface supérieure, de deux logements spécifiques **32,** davantage décrits en relation avec la figure 4. Ces logements spécifiques positionnés face à face au niveau de l'extrémité supérieure de la paroi **31,** sont de forme complémentaire aux zones **17** et **18** de l'élément getter **15.** En l'espèce, ils sont de forme sensiblement parallélépipédique.

En raison du décalage du centre de gravité **20** de l'élément getter **15,** ce dernier est susceptible de pivoter au sein de ces logements **32** par rapport à un axe d'articulation défini par la génératrice de l'arête inférieure interne **33** des zones **17** et **18.** On a représenté au sein des figures 2 et 3 cet axe d'articulation **33.** En termes mécaniques, le basculement a lieu lorsque le centre de gravité de l'élément getter **15** est externe au périmètre de sustentation dudit élément sur les logements **32,** lui-même formé par l'enveloppe des surfaces de coopération (ou superposition) des zones **17, 18,** et des logements **32.** Ce périmètre est formé sur la figure 3a, dans le cas exposé, par le rectangle qui joint ensemble les zones **17** et **18,** dont la face inférieure est l'axe **33** en trait mixte.

Ainsi donc, lorsque l'opérateur a déposé l'élément getter **15** au sein de la paroi latérale **31,** et plus particulièrement après avoir positionné les zones **17** et **18** dudit élément au sein des logements correspondants **32,** de par son propre poids et en raison de ses caractéristiques dimensionnelles (et notamment du décalage du centre de gravité **20),** l'élément getter **15** pivote naturellement et par gravité par rapport à l'axe **33** jusqu'à ce qu'une autre **34** de ses génératrices (dans ce cas d'espèce) vienne en contact avec le fond **30** du boitier (voir figure 3b). Ce faisant, l'extrémité opposée et notamment la génératrice opposée **35** de l'élément getter **15,** fait saillie par rapport au plan supérieur défini par la face supérieure **36** de la paroi latérale **31,** tel qu'on peut notamment l'observer sur la figure 3b.

D'ores et déjà, il convient de relever qu'en raison de la conformation particulière de l'élément getter **15,** celui-ci est sensiblement limité en déplacement selon les directions **X** et **Y** (par exemple matérialisées sur la figure 4) de par la forme particulière des évidements **32** et des zones complémentaires **17** et **18.** En d'autres termes, il ne dispose que d'un seul degré de liberté, à savoir la rotation par rapport à la génératrice **33.**

Par ailleurs, le dimensionnement de l'élément getter **15,** en relation avec son débattement en rotation libre avant de reposer sur le fond (en ce cas d'espèce) est tel qu'il dépasse légèrement au-delà de la surface supérieure de la paroi latérale **31.** Cette disposition représentée sur les figures 3b et 4 sera mieux comprise lors de l'opération suivante

On procède alors à la mise en place d'une préforme de brasage **40,** typiquement constituée d'un alliage d'or et d'étain, et reçue sur la face supérieure **36** de la paroi latérale **31.** On positionne sur cette préforme **40** directement un capot d'encapsulation ou alors, comme dans l'exemple décrit, un porte-fenêtre **41,** une seconde préforme de brasage **42** sur ledit porte-fenêtre **41,** et enfin, une fenêtre **43,** transparente à la gamme de longueurs d'onde d'intérêt pour le détecteur bolométrique **7.**

En raison du positionnement de ces éléments **40, 41, 42, 43,** l'élément getter **15** coopère par le biais de sa génératrice **35** avec la préforme de brasage **40,** induisant ainsi son basculement par rapport à l'axe **33** sensiblement selon la représentation schématique de la figure 5.

On observe que dans ce cas, l'élément getter **15** se trouve en porte-à-faux, et en particulier, en contact mécanique constant avec la préforme **40,** condition qui conduit au bon déroulement du processus en termes de qualité de l'assemblage final.

Le boitier ainsi défini est placé dans une enceinte au sein de laquelle est imposé le vide ou de manière générale l'ambiance atmosphérique recherchée (nature et pression du gaz), puis la température de ladite enceinte est élevée jusqu'à une valeur supérieure à la température de fusion des matériaux de brasage des préformes **40** et **42,** afin d'aboutir, de manière connue, au scellement hermétique du boitier.

En se référant à la figure 6, on peut observer la migration du matériau de brasage **40,** venant constituer une zone de fixation et de coopération **44** entre l'élément getter **15** et le porte-fenêtre **41.**

Il peut être cependant souhaité de fixer de manière plus ferme ledit élément getter, selon la disposition particulière représentée par la figure 7. A cette fin, on munit les zones **17** et **18** de l'élément getter d'au moins un orifice traversant **45,** permettant après fusion de la préforme **40,** l'écoulement partiel du matériau de brasage en zone inférieure jusqu'à la face inférieure des logements **32,** définissant une zone supplémentaire de fixation **46.** A cet effet, on munit avantageusement la face inférieure et le ou les orifices traversants des logements **32** d'une couche mouillable par le matériau de brasage.

On a décrit une forme particulière de réalisation de l'invention mettant en oeuvre deux logements **32** destinés à coopérer avec deux saillies émanant de l'élément getter. Cependant, l'invention doit s'entendre comme étant également susceptible de fonctionner avec un seul logement ménagé dans la paroi latérale, et apte à coopérer avec une seule saillie ou excroissance émanant de l'élément getter. L'important est la notion de porte à faux dudit élément getter, lorsqu'il est mis en place, par l'intermédiaire de la saillie ou excroissance, dans le logement prévu à cet effet, et corollairement, sa coopération avec la préforme de brasage.

On conçoit tout l'intérêt du procédé et du dispositif de l'invention dans la mesure où, lors de l'opération de scellement proprement dit du boitier hermétique, on aboutit concomitamment à l'orientation et à la fixation de l'élément getter au sein d'un tel boitier, sans nécessiter une quelconque étape supplémentaire. Cette opération est rendue possible de manière très simple par simple dimensionnement et conformation de l'élément getter, outre de la paroi latérale définissant ledit boitier, les autres étapes étant classiques. On aboutit à un gain de temps significatif, permettant dès lors une réduction des coûts de fabrication importante.

## Revendications

1. Procédé d'assemblage et de fermeture hermétique d'un boitier, constitué d'une paroi latérale (31) rapportée sur ou solidaire d'un substrat (30), le volume ainsi défini recevant au moins un composant (7) fonctionnant sous vide ou sous pression réduite, ou plus généralement sous ambiance atmosphérique contrôlée, ledit volume étant obturé par un capot supérieur (5, 41-43) scellé sur ladite paroi latérale (31), ce procédé consistant :
- à aménager au sein de la paroi latérale (31) au moins un évidement ou logement (32) au voisinage de son extrémité supérieure, ledit évidement ou logement étant apte à recevoir un élément fonctionnel (15), monté en porte-à-faux, ledit élément fonctionnel étant conformé de manière correspondante ;
- à mettre en place ledit élément fonctionnel (15) au sein du logement, ledit élément fonctionnel (15) présentant au moins une saillie ou excroissance (17, 18) apte à être reçue dans l'évidement ou le logement (32), le centre de gravité dudit élément fonctionnel étant disposé en dehors du périmètre de sustentation défini par la zone de coopération de ladite saillie ou excroissance (17, 18) avec le logement ou évidement (32), de telle sorte que l'élément fonctionnel (15) bascule d'une position non opérationnelle à une position opérationnelle lors du positionnement du capot supérieur sur la surface supérieure de la paroi latérale ;
- à déposer sur la face supérieure (36) de la paroi latérale (31) un élément de jonction métallique également qualifié de préforme de brasage (40) ;
- à déposer ledit capot supérieur (41 - 43) au-dessus et en contact avec ladite préforme de brasage (40), induisant la coopération dudit élément fonctionnel (15) avec la préforme de brasage (40), et corollairement le positionnement de l'élément fonctionnel (15) dans sa position opérationnelle ;
- à soumettre l'ensemble ainsi réalisé à l'ambiance souhaitée en termes de nature de gaz et de pression de fonctionnement du composant ;
- à élever la température à une valeur au moins supérieure à la température de fusion du matériau constitutif de la préforme de brasage ;
- puis à abaisser ladite température pour induire la solidification dudit matériau de brasage, et corollairement le scellement du capot supérieur sur la paroi latérale.

2. Procédé d'assemblage et de fermeture hermétique d'un boitier selon la revendication 1, ***caractérisé* en ce que** lors de l'élévation de température, le matériau de brasage de la préforme de brasage (40) migre et assure, en suite de sa fusion puis de sa solidification, la solidarisation de l'élément fonctionnel (15) au boiter.

3. Procédé d'assemblage et de fermeture hermétique d'un boitier selon la revendication 2, ***caractérisé* en ce que** l'élément fonctionnel (15) est percé d'au moins un orifice traversant (45) ménagé au niveau de ses zones de coopération (17, 18) avec le au moins un logement (32), et **en ce que** le matériau de brasage de la préforme (40) migre partiellement au travers de cet au moins un orifice traversant pour induire la fixation de l'élément fonctionnel avec ledit au moins un logement (32).

4. Procédé d'assemblage et de fermeture hermétique d'un boitier selon l'une des revendications 1 à 3, dans lequel
• le boitier est destiné à constituer un détecteur infrarouge,
• dans lequel, le volume défini par la paroi latérale (31) rapportée sur ou solidaire du substrat (30) reçoit au moins un détecteur bolométrique (7) fonctionnant sous vide ou sous pression réduite, ledit capot supérieur (5, 41 - 43) intégrant une fenêtre (43) transparente à la gamme de longueurs d'onde d'intérêt,
• et dans lequel l'élément fonctionnel (15) est un élément getter.

5. Dispositif composé d'un composant (7) intégré dans un boitier hermétique au sein duquel est susceptible de régner le vide ou une pression réduite, ou de manière générale une ambiance atmosphérique contrôlée, ledit boitier étant constitué d'une paroi latérale (31) rapportée sur ou solidaire d'un substrat (30), le volume ainsi défini étant obturé par scellement d'un capot supérieur (5, 41 - 43), dans lequel :
- la paroi latérale (31) présente au moins un évidement ou logement (32) au voisinage de son extrémité supérieure ;
- le boitier intègre également un élément fonctionnel (15) conformé de manière telle qu'il présente au moins une saillie ou excroissance (17, 18) reçue dans l'évidement ou le logement (32) ménagé au sein de la paroi latérale (31), et dont le centre de gravité est disposé en dehors du périmètre de sustentation défini par la zone de coopération de ladite saillie ou excroissance (17, 18) avec le logement ou évidement (32), de telle sorte que l'élément fonctionnel (15) a été basculé d'une position non opérationnelle à sa position opérationelle lors du positionnement du capot supérieur (5, 41 - 43) sur la surface supérieure de la paroi latérale définissant le boitier, ledit élément fonctionnel (15) étant solidarisé au boitier par un matériau de brasage (40) lors du scellement du capot supérieur (41, 42, 43) sur ladite paroi latérale (31).

6. Dispositif composé d'un composant (7) intégré dans un boitier hermétique selon la revendication 5, ***caractérisé* en ce que** la paroi latérale (31) présente deux évidements ou logements (32) au voisinage de son extrémité supérieure, lesdits évidements ou logements étant ménagés sensiblement de manière opposée l'un à l'autre, et corollairement **en ce que** l'élément fonctionnel (15) comporte deux saillies ou excroissances (17, 18) reçues dans lesdits évidements ou logements (32), le centre de gravité de l'élément fonctionnel (15) étant externe au périmètre de sustentation dudit élément, lui-même formé par l'enveloppe des périmètres de coopération entre les excroissances (17, 18) et les évidements ou logements (32), et la coopération des excroissances (17, 18) avec les évidements ou logements (32) constituant un axe d'articulation (33), autour duquel l'élément fonctionnel (15) a été basculé d'une position non opérationnelle à sa position opérationelle lors du positionnement du capot supérieur sur la surface supérieure de la paroi latérale définissant le boitier.

7. Dispositif selon l'une des revendications 5 et 6, destiné à l'imagerie infrarouge, dans lequel le composant (7) est constitué d'au moins un détecteur bolométrique (7) dans lequel ledit capot supérieur (5, 41 - 43) intègre une fenêtre (43) transparente à la gamme de longueurs d'onde d'intérêt et dans lequel l'élément fonctionnel (15) est un élément getter.

## Patentansprüche

1. Verfahren zum Zusammenbau und hermetischen Verschließen eines Gehäuse, bestehend aus einer Seitenwand (31), angebaut an oder fest verbunden mit einem Substrat (30), wobei der so definierte Raum mindestens ein Bauteil (7) aufnimmt, das im Vakuum oder bei Unterdruck oder, allgemeiner, in einer kontrollierten Atmosphäre arbeitet, wobei dieser Raum durch eine mit dieser Seitenwand (31) dicht verbundene obere Abdeckung (5, 41-43) abgeschlossen ist, dieses Verfahren besteht darin:
- innerhalb der Seitenwand (31) mindestens eine Aushöhlung oder Aussparung (32) in Nähe ihres oberen Endes vorzusehen, diese Aushöhlung oder Aussparung (32) ist in der Lage, ein funktionelles Element (15) aufzunehmen, das freitragend montiert ist, dieses funktionelle Element wird in entsprechender Art und Weise geformt;
- dieses funktionelle Element (15) innerhalb der Aussparung unterzubringen, dieses funktionelle Element (15) weist mindestens eine Ausbuchtung oder Auskragung (17, 18) auf, die in der Aushöhlung oder Aussparung (32) untergebracht werden kann, der Schwerpunkt dieses funktionellen Elementes ist außerhalb des Auftriebsperimeters untergebracht, definiert durch die Kooperationszone dieser Ausbuchtung oder Auskragung (17, 18) mit der Aushöhlung oder Aussparung (32), so dass das funktionelle Element (15) von einer nicht operativen Position in eine operative Position kippen kann, wenn die obere Abdeckung auf die Oberseite der Seitenwand aufgesetzt wird;
- auf der Oberseite (36) der Seitenwand (31) ein metallisches Verbindungselement, auch bezeichnet als Löt- Vorform (40) aufzulegen;
- diese obere Abdeckung (41 - 43) über und in Kontakt mit dieser Löt- Vorform (40) aufzulegen, was zur Kooperation dieses funktionellen Elementes (15) mit der Löt-Vorform (40) führt und gleichzeitig zur Positionierung des funktionellen Elementes (15) in der operativen Position;
- die so hergestellte Baugruppe der gewünschten Umgebung, abhängig von der Art des Gases und des Betriebsdrucks des Bauteils auszusetzen;
- die Temperatur auf einen Wert zu erhöhen, der mindestens über der Schmelztemperatur des Materials liegt, aus dem die Löt- Vorform besteht;
- dann die Temperatur zu senken um die Verfestigung des Lötmaterials zu bewirken und gleichzeitig die obere Abdeckung an der Seitenwand abzudichten.

2. Verfahren zum Zusammenbau und hermetischen Verschließen eines Gehäuses gemäß Anspruch 1, ***dadurch gekennzeichnet, dass*** bei der Erhöhung der Temperatur das Lötmaterial der Löt- Vorform (40) migriert und infolge seines Schmelzens und wieder Verfestigens die feste Verbindung des funktionellen Elementes (15) mit dem Gehäuse gewährleistet.

3. Verfahren zum Zusammenbau und hermetischen Verschließen eines Gehäuses gemäß Anspruch 2, **dadurch gekennzeichnet, dass** das funktionelle Element (15) von mindestens einer durchführenden Öffnung (45) durchbrochen ist, ausgespart in Höhe der Kooperationszonen (17, 18) mit der mindestens einen Aussparung (32), und dadurch dass das Lötmaterial der Vorform (40) teilweise durch diese eine durchführende Öffnung migriert, um die Befestigung des funktionellen Elementes an dieser mindestens einen Aussparung (32) zu induzieren.

4. Verfahren zum Zusammenbau und hermetischen Verschließen eines Gehäuses nach einem der Ansprüche 1 bis 3, bei dem
- das Gehäuse einen Infrarot- Detektor bilden soll,
- bei dem der von der angebauten auf oder fest mit einem Substrat (30) verbundenen Seitenwand (31) definierte Raum mindestens einen bolometrischen Detektor (7) aufnimmt, der im Vakuum oder bei Unterdruck arbeitet, wobei diese obere Abdeckung (5, 41-43) ein Fenster (43) enthält, das gegenüber der interessierenden Wellenlänge durchlässig ist, und bei dem das funktionelle Element (15) ein Getter-Element ist.

5. Vorrichtung bestehend aus einem Bauteil (7), integriert in ein hermetisch dichtes Gehäuse, in dem ein Vakuum oder ein Unterdruck herrscht, oder ganz allgemein eine kontrollierte Atmosphäre, dieses Gehäuse besteht aus einer Seitenwand (31) angebaut oder fest mit einem Substrat (30) verbundenen, das so definierte Volumen wird durch Abdichtung einer oberen Abdeckung (5, 41-43) definiert, bei der:
- die Seitenwand (31) mindestens eine Aushöhlung oder Aussparung (32) in Nähe des oberen Endes aufweist;
- das Gehäuse auch ein funktionelles Element (15) enthält, das so geformt ist, dass es mindestens eine Ausbuchtung oder Auskragung (17, 18) aufweist, die in der Aushöhlung oder Aussparung (32) untergebracht werden kann, die in der Seitenwand (31) angeordnet ist und deren Schwerpunkt außerhalb des Auftriebsperimeters untergebracht ist, definiert durch die Kooperationszone dieser Ausbuchtung oder Auskragung (17, 18) mit der Aushöhlung oder Aussparung (32), so dass das funktionelle Element (15) von einer nicht operativen Position in seine operative Position kippt, wenn die obere Abdeckung (5, 41-43) auf die Oberseite der Seitenwand aufgesetzt wird, die das Gehäuse definiert, dieses funktionelle Element (15) wird mittels eines Lötmaterials (40) bei der Abdichtung der oberen Abdeckung (41, 42, 43) mit dieser Seitenwand (31) fest mit dem Gehäuse verbunden.

6. Vorrichtung bestehend aus einem Bauteil (7), integriert in ein hermetisch dichtes Gehäuse gemäß Anspruch 5, ***dadurch gekennzeichnet, dass*** die Seitenwand (31) zwei Aushöhlungen oder Aussparungen (32) in Nähe des oberen Endes umfasst, diese Aushöhlungen oder Aussparungen sind im Wesentlichen einander gegenüberliegend angeordnet, und gleichzeitig dadurch, dass das funktionelle Element (15) zwei Ausbuchtungen oder Auskragungen (17, 18) umfasst, aufgenommen in diesen Aushöhlungen oder Aussparungen (32), der Schwerpunkt des funktionellen Elementes (15) liegt dabei außerhalb des Auftriebsperimeters dieses Elementes, das selbst wiederum definiert wird durch die Hülle der Kooperationsperimeter zwischen den Ausbuchtungen (17, 18) und den Aushöhlungen oder Aussparungen (32), und die Kooperation der Ausbuchtungen (17, 18) mit den Aushöhlungen oder Aussparungen (32), die eine Gelenkachse bilden (33) um die das funktionelle Element (15) aus einer nicht operativen Position in seine operative Position kippt, wenn die obere Abdeckung auf die Oberseite der Seitenwand aufgesetzt wird, die das Gehäuse definiert

7. Vorrichtung nach irgendeinem der Ansprüche 5 bis 6, bestimmt für die Infrarot-Bildgebung, in der das Bauteil (7) aus mindestens einem bolometrischen Detektor (7) besteht, wobei diese obere Abdeckung (5, 41-43) ein Fenster (43) enthält, das gegenüber der interessierenden Wellenlänge durchlässig ist, und in der das funktionelle Element (15) ein Getter-Element ist

## Claims

1. A method for assembling and hermetically sealing a package consisting of a side wall (31) mounted on, or integral with a substrate (30), with the space thus defined accommodating at least one component (7) that operates in a vacuum or at reduced pressure or, more generally, in a controlled atmosphere, said space being closed off by a hermetic sealing cover (5, 41-43) sealed on said side wall (31), with this method involving:
- providing in the side wall (31) at least one opening or recess (32) in the vicinity of its upper edge, said opening or recess being capable of accommodating a functional element (15) mounted so that it overhangs, said functional element being shaped accordingly;
- fitting said functional element (15) within said recess, said functional element (15) being provided with at least one protrusion or protuberance (17, 18) capable of being accommodated in the opening or recess (32), the center of gravity of said functional element being offset outside the support perimeter defined by area of said protrusion or protuberance (17, 18) which cooperates with the recess or opening (32), so that the functional element (15) is capable of swiveling from a non-operational position to an operational position when positioning the upper cover on the upper face of the side wall ;
- depositing a metallic connector element, also referred to as a brazing preform (40), onto the upper face (36) of the side wall (31);
- depositing the upper cover (41 - 43) on, and in contact with, said brazing preform (40), thereby causing cooperation of said functional element (15) with the brazing preform (40) and, consequently, positioning of the functional element in accordance with its operating mode;
- subjecting the assembly thus obtained to the desired environment in terms of the kind of gas and operating pressure of the component;
- increasing the temperature to a value that is at least in excess of the melting temperature of the material that constitutes the brazing preform;
- then lowering said temperature in order to cause solidification of said brazing material and, consequently, sealing of the upper cover on the side wall.

2. The method for assembling and hermetically sealing a package as claimed in claim 1, ***wherein,*** when the temperature is increased, the brazing material of the brazing preform (40) migrates and ensures, after melting and then solidifying, attachment of the functional element (15) to the package.

3. The method for assembling and hermetically sealing a package as claimed in claim 2, ***wherein*** the functional element (15) has at least one through-hole (45) in its areas (17, 18) which cooperate with the at least one recess (32) and the brazing material of preform (40) partially migrates through the at least one through-hole in order to obtain attachment of the functional element with said at least one recess (32).

4. A method for assembling and hermetically sealing a package according one claims 1 to 3, in which :
- the package is intendent to constitute an infrared detector,
- the space defined by said side wall (31) mounted on, or integral with the substrate (30), accommodates at least one bolometric detector (7) which operates in a vacuum or at reduced pressure, said upper cover (5, 41 - 43) including a window (43) that is transparent to the wavelength range that is of interest,
- the functional element (15) is a getter.

5. A device comprising a component (7) fitted in a hermetically sealed package inside which it is possible for there to be a vacuum or reduced pressure or, generally speaking, a controlled atmosphere, with said package consisting of a side wall (31) mounted on, or integral with, a substrate (30), with the space thus defined being closed off by sealing an upper cover (5, 41 - 43), wherein:
- the side wall (31) has at least one opening or recess (32) in the vicinity of its upper edge;
- the package also includes a functional element (15) shaped so that it has at least one protrusion or protuberance (17, 18) accommodated in the opening or recess (32) provided in side wall (31) and whose center of gravity is offset outside the support perimeter defined by area of said protrusion or protuberance (17, 18) which cooperates with the recess or opening (32), so that functional element (15) was swiveled from a non-operational position to an operational position after positioning of the upper cover (5, 41 - 43) on upper face of the side wall that defines the package, said functional element (15) being attached to the package by a brazing material (40) when the upper cover (5, 41 - 43) is sealed on said side wall (31).

6. The device comprising a component (7) contained in a hermetically sealed package as claimed in claim 5, ***wherein*** the side wall (31) has two openings or recesses (32) in the vicinity of its upper edge, said openings or recesses being made substantially opposite each other and, consequently, the functional element (15) has two protrusions or protuberances (17, 18) accommodated in said openings or recesses (32), with the center of gravity of the functional element (15) being outside the support perimeter of said element which is itself formed by the envelope of the cooperation perimeters between protuberances (17, 18) and openings or recesses (32), and cooperation of protuberances (17, 18) with openings or recesses (32) constituting an articulation axis (33) around which the functional element (15) has swiveled from a non-operational position to its operational position after positioning of the cover on the side wall that defines the package.

7. The device according to claims 5 and 6, for infrared imaging, in which the component (7) is at least one bolometer detector, in which said upper cover (5, 41 - 43) includes a window (43) that is transparent to the wavelength range that is of interest, and in which the functional element (15) is a getter element.
